# EUROPEAN PATENT SPECIFICATION

(11) **EP 3 567 388 B1**
(45) Date of publication and mention of the grant of the patent: **20.07.2022**
(21) Application number: 18171417.1
(22) Date of filing: 09.05.2018
(51) Int. Cl.: G01R 27/18, G01R 31/52

(54) **DETECTION OF EARTH LEAKAGE**
ERKENNUNG VON ERDSCHLÜSSEN
DÉTECTION DE FUITE À LA TERRE

(43) Date of publication of application: 13.11.2019
(73) Proprietor: Siemens Mobility GmbH, 81739 München (DE)
(72) Inventor: Zalud, Jan, 26601 Beroun (CZ)
(74) Representative: Deffner, Rolf

(56) References cited:
- EP-A1- 1 586 910
- WO-A1-2010/069739

## Description

### FIELD OF THE INVENTION

The present invention relates to a method for detecting earth leakage in the cabling of an insulated electric installation, such as an insulated railway signaling installation, the method comprising the steps of applying through a first resistor a first voltage between cabling and ground and measuring a resulting first current. The present invention also comprises a respective device.

The cabling of an insulated electric installation normally comprises insulated conductors which are used to carry electric signals, e.g. to a railway signal. Such cabling usually is buried in the ground. Cracks in the isolation can lead to earth leakage.

### STATE OF THE ART

A respective method and device for detecting earth leakage using this principle is e.g. known from EP 1 586 910 A1. This document, however, refers to detecting earth leakage in electrical networks which comprise rectifiers or converters on a semiconductor basis in the path of possible failure current. Typical railway signaling installations do not contain such rectifiers or converters and thus do not need complex devices as in EP 1 586 910 A1.

What is needed in railway applications is fail-safe earth leakage detection. Methods and devices need to guarantee a failure rate for detecting wrong earth leakage impedance values, e.g. according to the EN50129 norm.

Normally earth leakage detectors need regular manual supervision by maintenance personnel. This becomes more and more costly, even more because the trend for railway signaling installations is changing from centralized installation in one central building to many decentralized networks which are spread through the field, with many earth leakage detectors in remote switching cabinets in the field which detectors need to be regularly tested by maintenance personnel.

Many known earth leakage detectors provide only a simple output of the state - earth leakage or no earth leakage. There is no possibility to continuously read out impedance values to provide better diagnostic options for frequently only intermitting earth leaks, for example with changing humidity in the ground.

WO 2010/069739 A1 discloses a ground fault detection system for a generator in a power system.

### SUMMARY OF THE INVENTION

One object of the present invention is to provide a method for detecting earth leakage in the cabling of an insulated electric installation, such as an insulated railway signaling installation, which method allows for fail-safe operation and for check of faults in earth leakage detection without manual check at the place of the earth leakage detector.

The invention is defined by the independent claims.

According to the present invention, which comprises the steps of applying through a first resistor a first voltage between cabling and ground and measuring a resulting first current, this object is achieved in
that independently from the first resistor a second voltage between cabling and ground is applied through a second resistor and that the resulting second current is measured, and
that first and second resulting current, or variables derived from first and second resulting current, are compared, and that earth leakage is detected when the first resulting current, or a variable derived therefrom, deviates by a predefined amount from the current, or a respective variable derived therefrom, resulting from known first voltage and known first resistor, and the second resulting current, or a variable derived therefrom, deviates by a predefined amount from the current, or a respective variable derived therefrom, resulting from known second voltage and known second resistor.

Independently means that first and second voltage are applied via different components, i.e. via different resistors. The physical voltage source may be the same for first and second voltage. One could also use one physical voltage source for the first resistor and another physical voltage source for the second resistor. In any case one needs to precisely know the voltage that the source injects into the circuit.

So the invention uses two detectors, also called two channels, in parallel. The first channel is defined by the first voltage and the first resistor, the second channel by the second voltage and the second resistor. If both channels work properly both channels will give the same result.

As a consequence of the two channels, if one channel experiences a hardware failure, that is, its resulting current (or variable derived from it) would not deviate from the predefined current resulting from the known voltage and known resistor, although there exists an earth leakage, the resulting current (or variable derived from it) of the other channel still would deviate from the predefined current resulting from the known voltage and known resistor due to the earth leakage.

When the readings of both channels are not within a span justified by the tolerances of used parts and designed precision of the device representing the channels, the failure of the whole device, i.e. both channels, can be detected and a superordinate system can react to it thus maintaining the safe operation.

Since first and second resulting current is measured over time, especially continuously, and first and second voltage are known or measured over time, especially continuously, the resulting impedance or resistance values can be computed, read out and evaluated. Accordingly, intermitting earth leaks, for example with changing humidity in the ground, can be detected.

One embodiment of the invention is that from the first resulting current and the known first voltage a total first resistance is computed, and the difference to the known resistance of the first resistor is determined, and that from the second resulting current and the known second voltage a total second resistance is computed, and the difference to the known resistance of the second resistor is determined. So the variable derived from the current here is resistance.

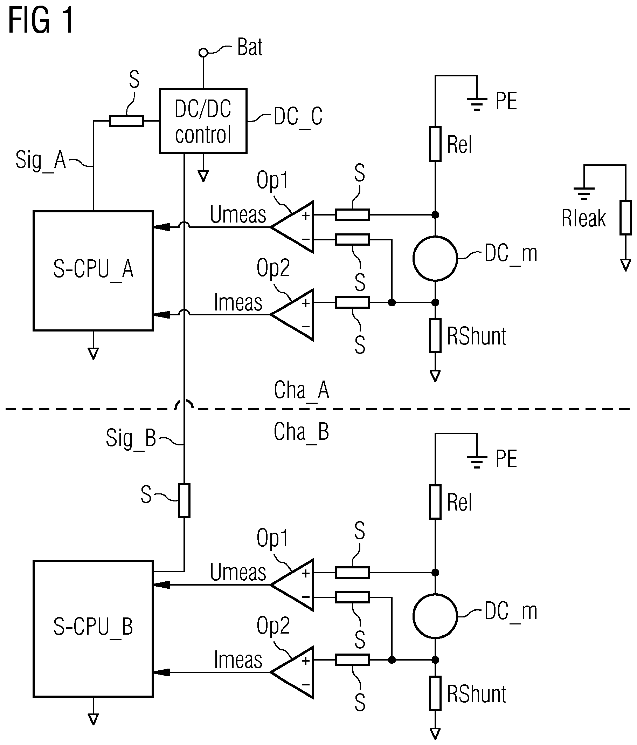

The principle for each channel here is that a known voltage is injected into the circuit of the channel via a known injecting resistor, then the current is measured and then the unknown earth fault leakage resistance is determined by subtracting the known injecting resistance, i.e. the resistance of resistor Rel in Fig. 1, from the Rtotal = U/I measured values. Hence Rleak = Rtotal - Rinjector. This is done for the first channel and for the second channel.

One embodiment of the invention is that first and second voltage is a DC voltage whereas a positive voltage of a predefined magnitude is applied during a predefined time and immediately afterwards a negative voltage of the same magnitude is applied during a predefined time, and/or whereas a negative voltage of a predefined magnitude is applied during a predefined time and immediately afterwards a positive voltage of the same magnitude is applied during a predefined time.

In this way only differential values of the first voltage and of the second voltage are measured. Any DC voltage which might be in series with the leak resistance to be determined, such as the battery supply voltage for the electric installation, can be cancelled out. So a known voltage (+ and - ) is injected into the circuit via a known injecting resistor, then the current is measured and then the unknown earth fault leakage resistance is determined by subtracting the known injecting resistance from the Rtotal=ΔU/ΔI measured values. Hence Rleak equals Rtotal minus Rinjector.

Accordingly, an embodiment of the invention consists in that for the first voltage the first resulting current and for the second voltage the second resulting current is determined as differential current, that is the current difference between the current resulting from the positive voltage and the current resulting from the negative voltage.

Usually both channels will be designed identical, that is that the first voltage is the same voltage as the second voltage, and that the first resistor has the same resistance as the second resistor.

When working with positive and negative voltages, usually the predefined time of the positive voltage is the same as the predefined time for the negative voltage.

Again, when working with positive and negative voltages for first and second voltage, first and second voltage can be applied one after another. This means that if the first voltage is applied there is no second voltage, and when the second voltage is applied, there is no first voltage.

A device for detecting earth leakage in the cabling of an insulated installation, such as an insulated railway signaling installation, according to the invention comprises
- a first resistor and a first voltage source designed to apply through the first resistor a first voltage between cabling and ground,
- a first measuring device designed to measure a resulting first current,
- a second resistor and a second voltage source designed to apply through the second resistor a second voltage between cabling and ground independently from the first voltage,
- a second measuring device designed to measure a resulting second current,
- a comparator which is designed to compare first and second resulting current, or variables derived from first and second resulting current, and to detect earth leakage when the first resulting current, or a variable derived therefrom, deviates by a predefined amount from the current, or a respective variable derived therefrom, resulting from known first voltage and known first resistor, and the second resulting current, or a variable derived therefrom, deviates by a predefined amount from the current, or a respective variable derived therefrom, resulting from known second voltage and known second resistor.

According to one embodiment of the device, first and second voltage source are designed to deliver first and second voltage, respectively, as DC voltage whereas a positive voltage of a predefined magnitude is applied during a predefined time and immediately afterwards a negative voltage of the same magnitude is applied during a predefined time, and/or whereas a negative voltage of a predefined magnitude is applied during a predefined time and immediately afterwards a positive voltage of the same magnitude is applied during a predefined time.

Especially, the first measuring device can be designed to determine the first resulting current as differential current, and the second measuring device can be designed to determine the second resulting current as differential current, the differential current being the current difference between the current resulting from the positive voltage and the current resulting from the negative voltage. First and second voltage source can be designed in a way that the first voltage is the same voltage as the second voltage, and that the first resistor has the same resistance as the second resistor. There can be one common voltage source as long as the voltage that it is injecting into the circuit is detected in a fail safe manner.

First and second voltage source can be designed in a way that the predefined time of the positive voltage is the same as the predefined time for the negative voltage.

First and second voltage source can be designed to apply first and second voltage one after another.

Since the present invention uses a two channel architecture, together with fail-safe argumentation according to the norm EN50129, the method and device according to the invention is fail-safe with a defined hazard rate and therefore can be used in railway signaling installations, without regular checks done by maintenance personnel.

### BRIEF DESCRIPTION OF FIGURES

The invention will be explained in closer detail by reference to a preferred embodiment, which is depicted schematically in the figures.
Fig. 1 shows a schematic electric circuit of a device according to an embodiment of the invention,
Fig. 2 shows a schematic function timeline.

### WAYS TO IMPLEMENT THE INVENTION

Fig. 1 shows an electric circuit according to an embodiment of the invention.

The invention is used for detecting possible earth leakages in cabling in insulated railway signaling installations. The insulated railway signaling installation has an internal DC source, e.g. a battery, which can be connected to the circuit via connection Bat. The battery in this example has a voltage of 48 V. The battery is connected to the DC/DC Control DC_C for battery, DC/DC Control DC_C is further connected to the floating IT network ground marked with a triangle.

The electric circuit contains two identical units, called channels, for determining the leak resistance Rleak between protective earthing PE and the floating IT network wires. The method can detect both, plus and minus wire leaks. The first channel is called channel A, Cha_A, the second channel is called channel B, Cha_B. Each unit or channel comprises a DC source DC_m for measurement, a resistor Rel, a resistor RShunt, two operational amplifiers Op1, Op2, several resistors S between the DC source DC_m and the operational amplifiers Op1,Op2 and a microprocessor S-CPU_A or S-CPU_B, respectively. Both channels Cha_A, Cha_B are identical.

In each channel Cha_A, Cha_B the DC source DC_m for measurement is connected via a relatively big resistor Rel, here with a resistance of 500 kOhm, to protective earthing PE and via a relatively small - in comparison to the resistor Rel - resistor RShunt, here with a resistance of 10 kOhm, to the floating IT network ground. For measuring the voltage Umeas a resistor S is connected from between the DC source DC_m and the resistor Rel to the non-inverting input of the first operational amplifier Op1, another resistor S is connected from between the DC source DC_m and the resistor RShunt to the inverting input of the first operational amplifier Op1. For measuring the resulting current Imeas a resistor S is connected from between the DC source DC_m and the resistor RShunt to the non-inverting input of the second operational amplifier Op2. The inverting input of the second operational amplifier Op2 is not connected. The output voltage of the first operational amplifier Op1 is the measured voltage Umeas. The measured voltage Umeas is lead to the respective microprocessor S-CPU_A, S-CPU_B, respectively. The output voltage of the second operational amplifier Op2 represents the measured resulting current Imeas. The measured resulting current Imeas is lead to the respective microprocessor S-CPU_A, S-CPU_B. Each microprocessor S-CPU_A, S-CPU_B is connected to the DC/DC Control DC_C to be able to send a respective signal Sig_A, Sig_B to the DC/DC Control DC_C.

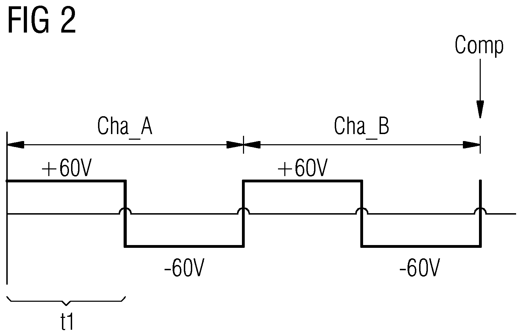

The measuring principle consists of injecting a DC voltage of a predefined magnitude during a predefined time alternating as a positive and as a negative voltage through the resistor Rel. For example first +60 V are injected for a time t1, then immediately afterwards -60 V are injected for the same time t1, then again immediately afterwards +60 V, then -60 V and so on, see Fig. 2. For the first two time periods t1, that is for +60 V and then -60 V, channel A CH_A does the measurement, that is the DC source DC_m of channel A is working and injecting the voltage in channel A, the DC source DC_m of channel B is idle. For the next two time periods t1, that is for +60 V and then -60 V, channel B does the measurement, that is the DC source DC_m of channel B is working and injecting the voltage in channel B, the DC source DC_m of channel A is idle. Then again, immediately afterwards or with a pause, the DC source DC_m of channel A will start working again, followed by the DC source DC_m of channel B, and so on.

For each channel A, B there will be a resulting voltage difference of 120 V measured as Umeas and a corresponding differential resulting current Imeas. From this voltage and current the leak resistance Rleak for this channel A, B is determined, here using the respective microprocessor S-CPU_A, S-CPU_B for this channel. Since the nature of the measurement is evaluation of differential values for voltage and current it is possible to cancel out any DC voltage that might be in series with the determined leak resistance Rleak, such as the battery voltage present in the 48 V circuit via the connection Bat.

If the leak resistance Rleak in a channel shows a deviation that is significant for an earth leakage then the respective microprocessor S-CPU_A, S-CPU_B sends a signal Sig_A, Sig_B to the DC/DC Control DC_C. This can be a so called kill signal that stops the action of the DC/DC Control DC_C. The DC/DC Control DC_C is used to disable the DC source of injected voltage DC_m in case a malfunction of the DC source DC_m is detected.

Since channel A and B work independently from each other in case of an earth leakage they should both give a respective signal Sig_A, Sig_B to the DC/DC Control DC_C. The comparator (not shown) compares signals Sig_A, Sig_B and will accept the detection of an earth leakage only if both channels A, B send a respective signal Sig_A, Sig_B. If the comparator receives a signal Sig_A, Sig_B just from one channel A,B then the device for earth leakage detection is not working properly. So for example the resulting leak resistance Rleak from channels A, B could be compared after one measurement in channel A and one measurement in channel B, as shown in Fig. 2 by the arrow labelled Comp. A.

Any hardware failure in the microprocessor S-CPU_A, S-CPU_B, in the operational amplifiers Op1, Op2 and their circuits (e.g. resistors S) or in the resistors Rel, RShunt will result in channels A and B reading values different from each other by more than the designed precision, e.g. more than 2%. Such irrelevant readings will be reported to a higher-level system as failure of the earth leakage detection and not as a hazard, like a earth leakage, for the railway signaling installation.

### LIST OF REFERENCE SIGNS

- Bat: connection for battery
- Cha_A: channel A
- Cha_B: channel B
- DC_C: DC/DC control for battery
- DC_m: DC source for measurement
- Imeas: resulting current
- Op1, Op2: operational amplifier
- PE: protective earthing
- Rel: first and second resistor
- Rleak: leak resistance
- RShunt: shunt resistor
- S: resistor
- S-CPU_A: microprocessor for channel A
- S-CPU_B: microprocessor for channel B
- Sig_A: signal for channel A
- Sig_B: signal for channel B
- t1: time period
- Umeas: measured voltage

## Claims

1. Method for detecting earth leakage in the cabling of an insulated electric installation, such as an insulated railway signaling installation, the method comprising the steps of applying through a first resistor (Rel) a first voltage between the cabling and ground (PE) and measuring a resulting first current (Imeas), wherein independently from the first resistor (Rel) a second voltage between the cabling and ground is applied through a second resistor (Rel) and that the resulting second current (Imeas) is measured, and that first and second resulting current, or variables derived from first and second resulting current, respectively, are compared, and that earth leakage is detected when the first resulting current (Imeas), or a variable derived therefrom, deviates by a predefined amount from the current, or a respective variable derived therefrom, resulting from known first voltage and known first resistor (Rel), and the second resulting current (Imeas), or a variable derived therefrom, deviates by a predefined amount from the current, or a respective variable derived therefrom, resulting from known second voltage and known second resistor (Rel).

2. Method according to claim 1, **characterized in that** from the first resulting current (Imeas) and the known first voltage a total first resistance is computed, and the difference to the known resistance of the first resistor (Rel) is determined, and that from the second resulting current (Imeas) and the known second voltage a total second resistance is computed, and the difference to the known resistance of the second resistor (Rel) is determined.

3. Method according to claim 1 or 2, **characterized in that** first and second voltage is a DC voltage whereas a positive voltage of a predefined magnitude is applied during a predefined time (t1) and immediately afterwards a negative voltage of the same magnitude is applied during a predefined time (t1), and/or whereas a negative voltage of a predefined magnitude is applied during a predefined time (t1) and immediately afterwards a positive voltage of the same magnitude is applied during a predefined time (t1).

4. Method according to claim 3, **characterized in that** for the first voltage the first resulting current (Imeas) and for the second voltage the second resulting current (Imeas) is determined as differential current, that is the current difference between the current resulting from the positive voltage and the current resulting from the negative voltage.

5. Method according to any of the preceding claims, **characterized in that** the first voltage is the same voltage as the second voltage, and that the first resistor (Rel) has the same resistance as the second resistor (Rel).

6. Method according to claim 3, **characterized in that** the predefined time (t1) of the positive voltage is the same as the predefined time (t1) for the negative voltage.

7. Method according to claim 3, **characterized in that** first and second voltage are applied one after another.

8. Device for detecting earth leakage in the cabling of an insulated installation, such as an insulated railway signaling installation, comprising
- a first resistor (Rel) and a first voltage source (DC_m) configured to apply through the first resistor a first voltage between the cabling and ground (PE),
- a first measuring device (Op1, Op2, S, S_CPU_A) configured to measure a resulting first current (Imeas), wherein the device further comprises
- a second resistor (Rel) and a second voltage source (DC_m) configured to apply through the second resistor a second voltage between the cabling and ground (PE) independently from the first voltage,
- a second measuring device (Op1, Op2, S, S_CPU_B) configured to measure a resulting second current (Imeas),
- a comparator which is configured to compare first and second resulting current (Imeas), or variables derived from first and second resulting current, respectively, and to detect earth leakage when the first resulting current (Imeas), or a variable derived therefrom, deviates by a predefined amount from the current, or a respective variable derived therefrom, resulting from known first voltage and known first resistor (Rel), and the second resulting current (Imeas), or a variable derived therefrom, deviates by a predefined amount from the current, or a respective variable derived therefrom, resulting from known second voltage and known second resistor (Rel).

9. Device according to claim 8, **characterized in that** first and second voltage source (DC_m) are configured to deliver first and second voltage, respectively, as DC voltage whereas a positive voltage of a predefined magnitude is applied during a predefined time (t1) and immediately afterwards a negative voltage of the same magnitude is applied during a predefined time (t1), and/or whereas a negative voltage of a predefined magnitude is applied during a predefined time (t1) and immediately afterwards a positive voltage of the same magnitude is applied during a predefined time (t1).

10. Device according to claim 9, **characterized in that** the first measuring device (Op1, Op2, S, S_CPU_A) is configured to determine the first resulting current (Imeas) as differential current, and **in that** the second measuring device (Op1, Op2, S, S_CPU_B) is configured to determine the second resulting current (Imeas) as differential current, the differential current being the current difference between the current resulting from the positive voltage and the current resulting from the negative voltage.

11. Device according to any of claims 8 to 10, **characterized in that** first and second voltage source (DC_m) are configured in a way that the first voltage is the same voltage as the second voltage, and that the first resistor (Rel) has the same resistance as the second resistor (Rel).

12. Device according to claim 9, **characterized in that** first and second voltage source (DC_m) are configured in a way that the predefined time (t1) of the positive voltage is the same as the predefined time (t1) for the negative voltage.

13. Device according to claim 9, **characterized in that** first and second voltage source (DC_m) are configured to apply first and second voltage one after another.

## Patentansprüche

1. Verfahren zur Erkennung von Erdschlüssen in der Verkabelung einer isolierten elektrischen Anlage, etwa einer isolierten Eisenbahnsignalanlage, wobei das Verfahren die Schritte des Anlegens durch einen ersten Widerstand (Rel) einer ersten Spannung zwischen der Verkabelung und Masse (PE) und des Messens eines resultierenden ersten Stroms (Imeas) umfasst, wobei unabhängig von dem ersten Widerstand (Rel) eine zweite Spannung zwischen der Verkabelung und Masse durch einen zweiten Widerstand (Rel) angelegt wird, und dass der resultierende zweite Strom (Imeas) gemessen wird und dass der erste und zweite resultierende Strom oder von dem ersten bzw. zweiten resultierenden Strom abgeleitete Variablen verglichen werden und dass ein Erdschluss erkannt wird, wenn der erste resultierende Strom (Imeas) oder eine davon abgeleitete Variable um einen vordefinierten Betrag von dem Strom oder einer davon abgeleiteten jeweiligen Variable, resultierend aus der bekannten ersten Spannung und dem bekannten ersten Widerstand (Rel), abweicht und der zweite resultierende Strom (Imeas) oder eine davon abgeleitete Variable um einen vordefinierten Betrag von dem Strom oder einer davon abgeleiteten jeweiligen Variable, resultierend aus der bekannten zweiten Spannung und dem bekannten zweiten Widerstand (Rel), abweicht.

2. Verfahren nach Anspruch 1, **dadurch gekennzeichnet, dass** aus dem ersten resultierenden Strom (Imeas) und der bekannten ersten Spannung ein erster Gesamtwiderstand berechnet wird und die Differenz zu dem bekannten Widerstandswert des ersten Widerstands (Rel) bestimmt wird und dass aus dem zweiten resultierenden Strom (Imeas) und der bekannten zweiten Spannung ein zweiter Gesamtwiderstand berechnet wird und die Differenz zu dem bekannten Widerstandswert des zweiten Widerstands (Rel) bestimmt wird.

3. Verfahren nach Anspruch 1 oder 2, **dadurch gekennzeichnet, dass** die erste und zweite Spannung eine Gleichspannung ist, wohingegen eine positive Spannung einer vordefinierten Stärke während einer vordefinierten Zeit (t1) angelegt wird und unmittelbar danach eine negative Spannung der gleichen Stärke während einer vordefinierten Zeit (t1) angelegt wird und/oder wohingegen eine negative Spannung einer vordefinierten Stärke während einer vordefinierten Zeit (t1) angelegt wird und unmittelbar danach eine positive Spannung der gleichen Stärke während einer vordefinierten Zeit (t1) angelegt wird.

4. Verfahren nach Anspruch 3, **dadurch gekennzeichnet, dass** für die erste Spannung der erste resultierende Strom (Imeas) und für die zweite Spannung der zweite resultierende Strom (Imeas) als Differenzstrom bestimmt wird, das ist die Stromdifferenz zwischen dem aus der positiven Spannung resultierenden Strom und dem aus der negativen Spannung resultierenden Strom.

5. Verfahren nach einem der vorhergehenden Ansprüche, **dadurch gekennzeichnet, dass** die erste Spannung die gleiche Spannung ist wie die zweite Spannung und dass der erste Widerstand (Rel) den gleichen Widerstandswert hat wie der zweite Widerstand (Rel).

6. Verfahren nach Anspruch 3, **dadurch gekennzeichnet,** die vordefinierte Zeit (t1) der positiven Spannung die gleiche ist wie die vordefinierte Zeit (t1) für die negative Spannung.

7. Verfahren nach Anspruch 3, **dadurch gekennzeichnet, dass** die erste und zweite Spannung nacheinander angelegt werden.

8. Einrichtung zur Erkennung von Erdschlüssen in der Verkabelung einer isolierten elektrischen Anlage, etwa einer isolierten Eisenbahnsignalanlage, die Folgendes umfasst:
- einen ersten Widerstand (Rel) und eine erste Spannungsquelle (DC_m), die dazu ausgebildet ist, durch den Widerstand eine erste Spannung zwischen der Verkabelung und Masse (PE) anzulegen,
- eine erste Messeinrichtung (Op1,Op2, S, S_CPU_A), die dazu ausgebildet ist, einen resultierenden ersten Strom (Imeas) zu messen, wobei die Einrichtung ferner Folgendes umfasst:
- einen zweiten Widerstand (Rel) und eine zweite Spannungsquelle (DC_m), die dazu ausgebildet ist, durch den zweiten Widerstand eine zweite Spannung zwischen der Verkabelung und Masse (PE) unabhängig von der ersten Spannung anzulegen,
- eine zweite Messeinrichtung (Op1,Op2, S, S_CPU_B), die dazu ausgebildet ist, einen resultierenden zweiten Strom (Imeas) zu messen,
- einen Vergleicher, der dazu ausgebildet ist, den ersten und zweiten resultierenden Strom (Imeas) oder von dem ersten bzw. zweiten Strom abgeleitete Variablen zu vergleichen und einen Erdschluss zu erkennen, wenn der erste resultierende Strom (Imeas) oder eine davon abgeleitete Variable um einen vordefinierten Betrag von dem Strom oder einer jeweiligen davon abgeleitete Variablen, resultierend aus der ersten bekannten Spannung und dem ersten bekannten Widerstand (Rel), abweicht, und der zweite resultierende Strom (Imeas) oder eine davon abgeleitete Variable um einen vordefinierten Betrag von dem Strom oder einer jeweiligen davon abgeleiteten Variablen, resultierend aus der zweiten bekannten Spannung und dem zweiten bekannten Widerstand (Rel), abweicht.

9. Einrichtung nach Anspruch 8, **dadurch gekennzeichnet, dass** die erste und zweite Spannungsquelle (DC_m) dazu ausgebildet sind, die erste bzw. zweite Spannung als Gleichspannung zu liefern, wohingegen eine positive Spannung einer vordefinierten Stärke während einer vordefinierten Zeit (t1) angelegt wird und unmittelbar danach eine negative Spannung der gleichen Stärke während einer vordefinierten Zeit (t1) angelegt wird und/oder wohingegen eine negative Spannung einer vordefinierten Stärke während einer vordefinierten Zeit (t1) angelegt wird und unmittelbar danach eine positive Spannung der gleichen Stärke während einer vordefinierten Zeit (t1) angelegt wird.

10. Einrichtung nach Anspruch 9, **dadurch gekennzeichnet, dass** die erste Messeinrichtung (Op1, Op2, S, S_CPU_A) dazu ausgebildet ist, den ersten resultierenden Strom (Imeas) als Differenzstrom zu bestimmen, und dadurch, dass die zweite Messeinrichtung (Op1, Op2, S, S_CPU_B) dazu ausgebildet ist, den zweiten resultierenden Strom (Imeas) als Differenzstrom zu bestimmen, wobei der Differenzstrom die Stromdifferenz zwischen dem aus der positiven Spannung resultierendem Strom und dem aus der negativen Spannung resultierenden Strom ist.

11. Einrichtung nach einem der Ansprüche 8 bis 10, **dadurch gekennzeichnet, dass** die erste und zweite Spannungsquelle (DC_m) derart ausgebildet sind, dass die erste Spannung die gleiche Spannung ist wie die zweite Spannung und dass der erste Widerstand (Rel) den gleichen Widerstandswert aufweist wie der zweite Widerstand (Rel).

12. Einrichtung nach Anspruch 9, **dadurch gekennzeichnet, dass** die erste und zweite Spannungsquelle (DC_m) derart ausgebildet sind, dass die vordefinierte Zeit (t1) der positiven Spannung die gleiche ist wie die vordefinierte Zeit (t1) für die negative Spannung.

13. Einrichtung nach Anspruch 9, **dadurch gekennzeichnet, dass** die erste und zweite Spannungsquelle (DC_m) dazu ausgebildet sind, die erste und zweite Spannung nacheinander anzulegen.

## Revendications

1. Procédé de détection de courant de fuite à la terre dans le câblage d'une installation électrique isolée, comme une installation de signalisation isolée de chemin de fer, le procédé comprenant l'application, à travers une première résistance (Re1), une première tension entre le câblage et la terre (PR), la mesure d'une première intensité résultante (Imeas), dans lequel, indépendamment de la première résistance (Re1), une seconde tension entre le câblage et la terre est appliquée à travers une seconde résistance (Re1), la seconde intensité résultante (Imeas) est mesurée, et les premières et secondes intensités résultantes, ou des variables dérivées des premières et secondes intensités résultantes, respectivement, sont comparées, et le courant de fuite à la terre est détecté quand la première intensité résultante (Imeas) ou une variable dérivée de cette dernière, résultant de la première tension connue et de la première résistance connue (Re1), dévie d'une quantité prédéfinie du courant ou d'une variable respective dérivée de ce dernier, et la seconde intensité résultante (Imeas) ou une variable dérivée de cette dernière, dévie d'une quantité prédéfinie du courant ou d'une variable respective dérivée de ce dernier, résultant de la seconde tension connue et de la seconde résistance connue (Re1).

2. Procédé selon la revendication 1, **caractérisé en ce qu'**à partir de la première intensité résultante (Imeas) et de la première tension connue, une première résistance totale est calculée, et la différence avec la résistance connue de la première résistance (Re1) est déterminée, et **en ce qu'**à partir de la seconde intensité résultante (Imeas) et de la seconde tension connue, une seconde résistance totale est calculée, et la différence avec la résistance connue de la seconde résistance (Re1) est déterminée.

3. Procédé selon la revendication 1 ou 2, **caractérisé en ce que** la première et la seconde tension est une tension continue, tandis qu'une tension positive d'une valeur prédéfinie est appliquée pendant une durée prédéfinie (t1), et immédiatement après, une tension négative de même valeur est appliquée pendant une durée prédéfinie (t1) et/ou tandis qu'une tension négative d'une valeur prédéfinie est appliquée pendant une durée prédéfinie (t1), et immédiatement après, une tension positive de même valeur est appliquée pendant une durée prédéfinie (t1).

4. Procédé selon la revendication 3, **caractérisé en ce que** pour la première tension, la première intensité résultante (Imeas) et pour la seconde tension, la seconde intensité résultante (Imeas) sont déterminées comme des courants différentiels, c'est-à-dire la différence d'intensité entre l'intensité résultant de la tension positive et l'intensité résultant de la tension négative.

5. Procédé selon l'une quelconque des revendications précédentes, **caractérisé en ce que** la première tension est la même tension que la seconde tension, et **en ce que** la première résistance (Re1) a la même résistance que la seconde résistance (Re1).

6. Procédé selon la revendication 3, **caractérisé en ce que** la durée prédéfinie (t1) de la tension positive est la même que la durée prédéfinie (t1) pour la tension négative.

7. Procédé selon la revendication 3, **caractérisé en ce que** la première et la seconde tension sont appliquées l'une après l'autre.

8. Appareil pour détecter un courant de fuite à la terre dans le câblage d'une installation électrique isolée, comme une installation de signalisation isolée de chemin de fer, comprenant une première résistance (Re1) et une première source de tension (DC_m) conçue pour appliquer à travers la première résistance une première tension entre le câblage et la terre (PE),
- un premier appareil de mesure (Op1, Op2, S, S_CPU_A) conçu pour mesurer une première intensité résultante (Imeas), l'appareil comprenant en outre :
- une seconde résistance (Re1) et une seconde source de tension (DC_m) conçue pour appliquer à travers la seconde résistance une seconde tension entre le câblage et la terre (PE) indépendamment de la première tension,
- un second appareil de mesure (Op1, Op2, S, S_CPU_B) conçu pour mesurer une seconde intensité résultante (Imeas),
- un comparateur conçu pour comparer les premières et secondes intensités résultantes (Imeas), ou des variables dérivées des premières et secondes intensités résultantes, respectivement, et pour détecter un courant de fuite à la terre quand la première intensité résultante (Imeas) ou une variable dérivée de cette dernière, dévie d'une quantité prédéfinie du courant ou d'une variable respective dérivée de ce dernier, résultant de la première tension connue et de la première résistance connue (Re1) et la seconde intensité résultante (Imeas) ou une variable dérivée de cette dernière, dévie d'une quantité prédéfinie du courant ou d'une variable respective dérivée de ce dernier, résultant de la seconde tension connue et de la seconde résistance connue (Re1).

9. Procédé selon la revendication 8, **caractérisé en ce que** la première et la seconde source te tension (DC_m) sont conçues pour délivrer une première et une seconde tensions, respectivement, en tant que tensions continues, tandis qu'une tension positive d'une valeur prédéfinie est appliquée pendant une durée prédéfinie (t1), et immédiatement après, une tension négative de même valeur est appliquée pendant une durée prédéfinie (t1) et/ou tandis qu'une tension négative d'une valeur prédéfinie est appliquée pendant une durée prédéfinie (t1), et immédiatement après, une tension positive de même valeur est appliquée pendant une durée prédéfinie (t1).

10. Procédé selon la revendication 9, **caractérisé en ce que** le premier appareil de mesure (Op1, Op2, S, S_CPU_A) est conçu pour déterminer la première intensité résultante (Imeas) en tant que courant différentiel, et **en ce que** le second appareil de mesure (Op1, Op2, S, S_CPU_B) est conçu pour déterminer la seconde intensité résultante (Imeas) en tant que courant différentiel, le courant différentiel étant la différence d'intensité entre l'intensité résultant de la tension positive et l'intensité résultant de la tension négative.

11. Procédé selon l'une quelconque des revendications 8 à 10, **caractérisé en ce que** la première source de tension (DC_m) et la seconde source de tension (DC_m) sont conçues de sorte que la première tension soit la même tension que la seconde tension, et que la première résistance (Re1) ait la même résistance que la seconde résistance (Re1).

12. Procédé selon la revendication 9, **caractérisé en ce que** la première source de tension (DC_m) et la seconde source de tension (DC_m) sont conçues de sorte que la durée prédéfinie (t1) de la tension positive soit la même que la durée prédéfinie (t1) pour la tension négative.

13. Procédé selon la revendication 9, **caractérisé en ce que** la première et la seconde source de tension (DC_m) sont conçues pour appliquer la première et la seconde tension l'une après l'autre.
